# EUROPÄISCHE PATENTSCHRIFT

(11) **EP 3 323 020 B1**
(45) Veröffentlichungstag und Bekanntmachung des Hinweises auf die Patenterteilung: **16.09.2020**
(21) Anmeldenummer: 16735594.0
(22) Anmeldetag: 20.06.2016
(51) Int. Cl.: G03F 7/20, G21K 1/06, G02B 27/00

(54) **SPIEGEL, INSBESONDERE FÜR EINE MIKROLITHOGRAPHISCHE PROJEKTIONSBELICHTUNGSANLAGE**
MIRROR, IN PARTICULAR FOR A MICROLITHOGRAPHIC PROJECTION EXPOSURE APPARATUS
MIROIR, NOTAMMENT DESTINÉ À UN DISPOSITIF D'ÉCLAIRAGE PAR PROJECTION MICROLITHOGRAPHIQUE

(30) Priorität: 15.07.2015 DE 102015213273
(43) Veröffentlichungstag der Anmeldung: 23.05.2018
(73) Patentinhaber: Carl Zeiss SMT GmbH, 73447 Oberkochen (DE)
(72) Erfinder: HILD, Kerstin, 73529 Schwäbisch Gmünd (DE); GRUNER, Toralf, 73433 Aalen (DE)
(74) Vertreter: Frank, Hartmut
(86) Internationale Anmeldenummer: PCT/EP2016/064174
(87) Internationale Veröffentlichungsnummer: WO 2017/009005

(56) Entgegenhaltungen:
- DE-A1-102005 044 716
- DE-A1-102011 081 603
- DE-A1-102013 219 583

## Beschreibung

### HINTERGRUND DER ERFINDUNG

### Gebiet der Erfindung

Die Erfindung betrifft einen Spiegel, insbesondere für eine mikrolithographische Projektionsbelichtungsanlage.

### Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (= Photoresist) beschichtetes und in der Bildebene des Projektionsobjektivs angeordnetes Substrat (z.B. einen Siliziumwafer) projiziert, um die Maskenstruktur auf die lichtempfindliche Beschichtung des Substrats zu übertragen.

In für den EUV-Bereich ausgelegten Projektionsobjektiven, d.h. bei Wellenlängen von z.B. etwa 13 nm oder etwa 7 nm, werden mangels Verfügbarkeit geeigneter lichtdurchlässiger refraktiver Materialien Spiegel als optische Komponenten für den Abbildungsprozess verwendet.

Dabei ist es auch bekannt, einen oder mehrere Spiegel in einem EUV-System als adaptiven Spiegel mit einer Aktuatorschicht aus einem piezoelektrischen Material auszugestalten, wobei über diese piezoelektrische Schicht hinweg ein elektrisches Feld mit lokal unterschiedlicher Stärke durch Anlegen einer elektrischen Spannung an beiderseitig zur piezoelektrischen Schicht angeordnete Elektroden erzeugt wird. Bei lokaler Verformung der piezoelektrischen Schicht verformt sich auch der Reflexionsschichtstapel des adaptiven Spiegels, so dass durch geeignete Ansteuerung der Elektroden beispielsweise Abbildungsfehler (ggf. auch zeitlich veränderliche Abbildungsfehler) wenigstens teilweise kompensiert werden können.

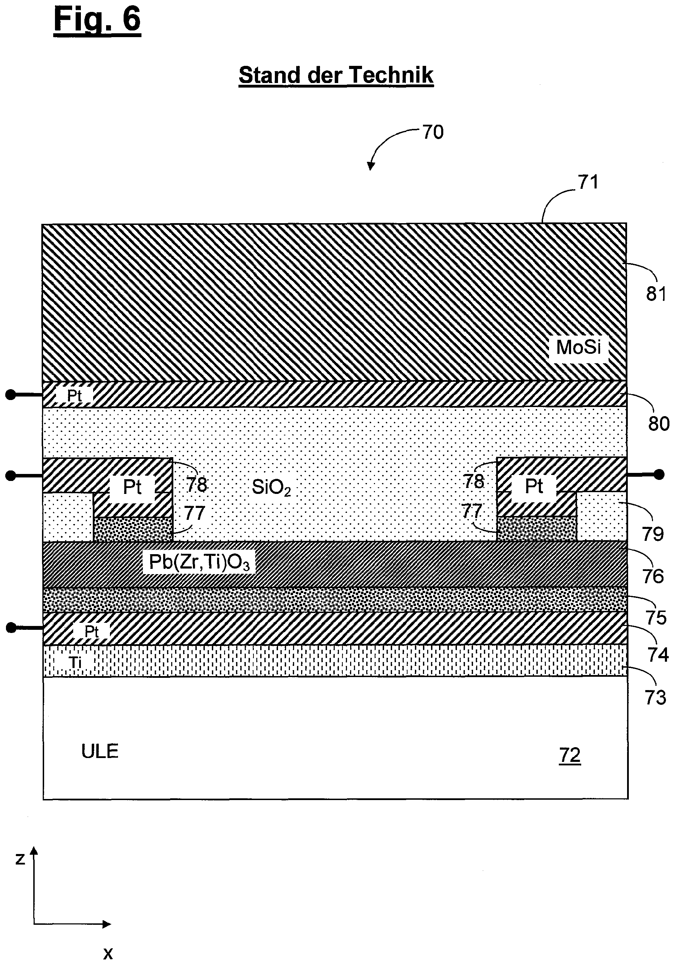

Fig. 6 zeigt in lediglich schematischer Darstellung einen prinzipiell möglichen Aufbau eines herkömmlichen adaptiven Spiegels 70. Der Spiegel 70 mit optischer Wirkfläche 71 weist zwischen einem Spiegelsubstrat 72 und einem Reflexionsschichtstapel 81 (z.B. als Vielfachschichtsystem aus Molybdän- und Siliziumschichten) eine piezoelektrische Schicht 76 auf, welche aus einem piezoelektrischen Material wie z.B. Blei-Zirkonat-Titanat (Pb(Zr,Ti)O₃) hergestellt ist. Andere in Frage kommende Materialien sind z.B. Aluminium-Nitrid (AlN), Aluminium-Scandium-Nitrid (AlScN) oder Blei-Magnesium-Niobat (PbMgNb). Bei dem Spiegelsubstratmaterial kann es sich z.B. um Titandioxid (TiO₂)-dotiertes Quarzglas handeln, wobei beispielhaft die unter den Markenbezeichnungen ULE® (der Firma Corning Inc.) oder Zerodur® (der Firma Schott AG) vertriebenen Materialien verwendbar sind. Die piezoelektrische Schicht 76 ist zwischen einer ersten Elektrodenanordnung 74, welche gemäß Fig. 6 auf einer auf dem Spiegelsubstrat 72 vorgesehenen Haftschicht 73 (im Beispiel aus Titan (Ti)) aufgebracht ist, und einer zweiten strukturierten Elektrodenanordnung 78 angeordnet, wobei sich zwischen den Elektrodenanordnungen 74 und 78 und der piezoelektrischen Schicht 76 jeweils noch eine Pufferschicht 75 bzw. 77 (im Beispiel aus LaNiO₃) befindet. Die Pufferschicht 75 bzw. 77 dient dazu, möglichst optimale kristalline Anwachsbedingungen für die piezoelektrische Schicht bereitzustellen.

Ferner befindet sich gemäß Fig. 6 auf der der strukturierten Elektrode 78 zugewandten Unterseite des Reflexionsschichtstapels 81 eine (grundsätzlich optionale) Strahlungsabschirmschicht 80 (welche im Beispiel ebenso wie die Elektroden 74, 78 aus Platin (Pt) hergestellt ist) und zum Schutz der darunterliegenden Schichten, insbesondere einer aus SiO₂ hergestellten Glättschicht 79, vor eindringender EUV-Strahlung dient. Durch das Anlegen einer lokal variierenden elektrischen Spannung kann eine örtlich variierende Auslenkung der piezoelektrischen Schicht 76 erzeugt werden, welche wiederum in eine Deformation des Reflexionsschichtstapels 81 und damit in eine Wellenfrontänderung für auf die optische Wirkfläche 71 auftreffendes Licht übersetzt wird und z.B. zur Aberrationskorrektur eingesetzt werden kann.

Ursache für solche im Betrieb einer für EUV ausgelegten Projektionsbelichtungsanlage auftretenden Aberrationen kann z.B. sein, dass die EUV-Spiegel insbesondere infolge der Absorption der von der EUV-Lichtquelle emittierten Strahlung eine Erwärmung und eine damit einhergehende thermische Ausdehnung bzw. Deformation erfahren, welche wiederum eine Beeinträchtigung der Abbildungseigenschaften des optischen Systems zur Folge haben kann. Dies ist insbesondere dann der Fall, wenn Beleuchtungssettings mit vergleichsweise kleinen Beleuchtungspolen (z.B. in Dipol- oder Quadrupol-Beleuchtungssettings) eingesetzt werden, in welchen die Spiegelerwärmung bzw. -deformation über die optische Wirkfläche des Spiegels hinweg stark variiert.

Ein weiteres, im Betrieb des vorstehend beschriebenen adaptiven Spiegels 70 auftretendes Problem besteht darin, dass außer von den vorstehend beschriebenen Elektrodenanordnungen 74, 78 auch von deren zur Spannungsbeaufschlagung vorgesehenen Zuleitungen ein elektrisches Feld erzeugt wird, welches am Ort der piezoelektrischen Schicht 76 ebenfalls einen piezoelektrischen Effekt hervorrufen und infolgedessen einen unerwünschten sowie nicht kontrollierbaren Beitrag zur Spiegeldeformation leisten kann.

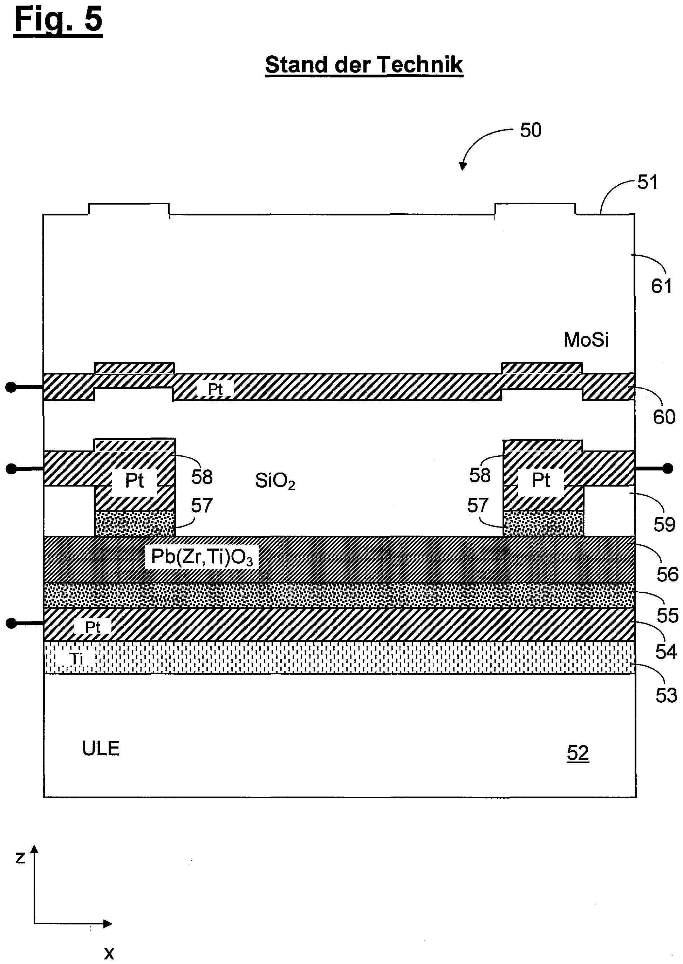

Ein noch weiteres, in der Praxis auftretendes Problem ist in Fig. 5 veranschaulicht, wobei im Vergleich zu Fig. 6 analoge bzw. im Wesentlichen funktionsgleiche Komponenten mit um "20" verringerten Bezugsziffern bezeichnet sind. Dieses weitere Problem besteht darin, dass die im Aufbau des adaptiven Spiegels 50 vorhandenen unterschiedlichen Materialien voneinander verschiedene thermische Ausdehnungskoeffizienten besitzen mit der Folge, dass z.B. auch bei einem homogenen Temperaturanstieg des Spiegels bestimmte Spiegelbereiche - im konkreten Beispiel die strukturierten Bereiche der im Reflexionsschichtstapel 61 zugewandten Elektrodenanordnung 58 infolge deren vom umgebenden Quarzmaterial der Glättschicht 59 abweichenden thermischen Ausdehnungskoeffizienten - eine stärkere relative Ausdehnung erfahren als die jeweils in lateraler Richtung benachbarten Spiegelbereiche. Dieser unerwünschte Effekt hat zur Folge, dass, wie in Fig. 5 lediglich schematisch angedeutet, sich die Struktur der oberen Elektrodenanordnung 58 in die optische Wirkfläche 51 "hineinprägt", also ebenfalls einen unerwünschten Beitrag zur Spiegeldeformation liefert.

Zum Stand der Technik wird lediglich beispielhaft auf DE 10 2011 081 603 A1 und DE 10 2011 005 940 A1 verwiesen.

### ZUSAMMENFASSUNG DER ERFINDUNG

Es ist eine Aufgabe der vorliegenden Erfindung, einen Spiegel, insbesondere für eine mikrolithographische Projektionsbelichtungsanlage, bereitzustellen, welcher eine Deformation bzw. Aktuierung über die z.B. zur Aberrationskorrektur erforderlichen Verfahrwege unter Vermeidung der vorstehend beschriebenen Probleme ermöglicht.

Diese Aufgabe wird durch den Spiegel gemäß den Merkmalen des unabhängigen Patentanspruchs 1 gelöst.

Ein erfindungsgemäßer Spiegel, wobei der Spiegel eine optische Wirkfläche aufweist, weist auf:
- ein Spiegelsubstrat;
- einen Reflexionsschichtstapel zur Reflexion von auf die optische Wirkfläche auftreffender elektromagnetischer Strahlung; und
- wenigstens eine piezoelektrische Schicht, welche zwischen Spiegelsubstrat und Reflexionsschichtstapel angeordnet und über eine erste, auf der dem Reflexionsschichtstapel zugewandten Seite der piezoelektrischen Schicht befindliche Elektrodenanordnung und eine zweite, auf der dem Spiegelsubstrat zugewandten Seite der piezoelektrischen Schicht befindliche Elektrodenanordnung mit einem elektrischen Feld zur Erzeugung einer lokal variablen Deformation beaufschlagbar ist;
- wobei die erste Elektrodenanordnung und/oder die zweite Elektrodenanordnung eine Mehrzahl von Elektroden aufweist, welche jeweils über eine Zuleitung mit einer elektrischen Spannung bezogen auf die jeweils andere Elektrodenanordnung beaufschlagbar sind;
- wobei ferner eine Abschirmschicht aus elektrisch leitendem Material derart angeordnet ist, dass sie ein von diesen Zuleitungen erzeugtes elektrisches Feld wenigstens teilweise von der piezoelektrischen Schicht abschirmt;
- wobei die Abschirmschicht aus einem Material mit einer elektrischen Leitfähigkeit von mehr als 10⁶ Siemens/Meter (S/m) hergestellt ist.

Der vorliegenden Erfindung liegt insbesondere das Konzept zugrunde, eine Abschirmschicht aus elektrisch leitendem Material derart im Schichtaufbau des adaptiven Spiegels vorzusehen, dass eine wirksame Abschirmung des von den Zuleitungen der dem Reflexionsschichtstapel zugewandten Elektrodenanordnung ausgehenden elektrischen Feldes erzielt wird, wobei zugleich der erwünschte piezoelektrische Effekt der einzelnen Elektroden der besagten, dem Reflexionschichtstapel zugewandten Elektrodenanordnung in der piezoelektrischen Schicht unbeeinflusst bleibt. Hierzu wird insbesondere, wie im Weiteren noch näher erläutert, die erfindungsgemäße Abschirmschicht auf der der piezoelektrischen Schicht abgewandten Seite der die Mehrzahl von Elektroden aufweisenden Elektrodenanordnung vorgesehen und weist Durchgangslöcher für die Zuleitungen der Elektroden dieser Elektrodenanordnung auf, durch welche die besagten Zuleitungen sich in zur optischen Wirkfläche senkrechter Richtung bzw. entlang der Stapelrichtung des Reflexionsschichtstapels hindurch erstrecken.

Bei dem Spiegel kann es sich insbesondere um einen Spiegel für eine mikrolithographische Projektionsbelichtungsanlage handeln. Die Erfindung ist jedoch nicht hierauf beschränkt. In weiteren Anwendungen kann ein erfindungsgemäßer Spiegel auch z.B. in einer Anlage für Maskenmetrologie eingesetzt bzw. verwendet werden.

Gemäß einer Ausführungsform ist zwischen der piezoelektrischen Schicht und der die Mehrzahl von Elektroden aufweisenden Elektrodenanordnung ferner eine Vermittlerschicht aus einem Material mit einer elektrischen Leitfähigkeit von weniger als 200 Siemens/Meter (S/m) angeordnet. Eine solche Vermittlerschicht dient dazu, zwischen den Elektroden der Elektrodenanordnung im Potential zu "vermitteln", indem ein zwischen benachbarten Elektroden bestehender Spannungsunterschied im Wesentlichen über der Vermittlerschicht abfällt. Infolge der geringen elektrischen Leitfähigkeit dieser Vermittlerschicht kann diese jedoch ein von den Zuleitungen der Elektroden ausgehendes elektrisches Feld nicht signifikant abschirmen mit der Folge, dass dieses elektrische Feld in der piezoelektrischen Schicht einen unerwünschten piezoelektrischen Effekt hervorrufen kann, so dass die erfindungsgemäße Wirkung insbesondere auch in Kombination mit einer solchen Vermittlerschicht zum Tragen kommt.

Gemäß einer Ausführungsform weist das Material der Vermittlerschicht Titandioxid (TiO₂), LaCoO₃, LaMnO₃ oder LaCaMnO₃ auf.

In Ausführungsformen können auch beide Elektrodenanordnungen jeweils eine Vielzahl von Elektroden aufweisen (in welchem Falle die Verkabelung, die Kontaktierung, die Vermittlerschicht und die Abschirmschicht jeweils zweifach vorzusehen sind).

Gemäß einer Ausführungsform ist die Abschirmschicht auf der der piezoelektrischen Schicht abgewandten Seite der die Mehrzahl von Elektroden aufweisenden Elektrodenanordnung angeordnet.

Gemäß einer Ausführungsform weisen die Zuleitungen jeweils einen ersten, senkrecht zur Stapelrichtung des Reflexionsschichtstapels verlaufenden Abschnitt und einen zweiten, in Stapelrichtung des Reflexionsschichtstapels verlaufenden Abschnitt (auch als "Via" oder "Durchkontaktierung" bezeichnet) auf. Eine solche Ausgestaltung ist jedoch nicht zwingend erforderlich, wobei die Zuleitungen in weiteren Ausführungsformen auch mit lediglich einem senkrecht zur Stapelrichtung verlaufenden Abschnitt (in zweidimensionaler Auslegung und ohne "Vias") realisiert werden können.

Gemäß einer Ausführungsform ist die Abschirmschicht zwischen den ersten, senkrecht zur Stapelrichtung des Reflexionsschichtstapels verlaufenden Abschnitten der Zuleitungen und der die Mehrzahl von Elektroden aufweisenden Elektrodenanordnung angeordnet.

Gemäß einer Ausführungsform weist die Abschirmschicht Durchgangslöcher zur Hindurchführung der Zuleitungen auf. Diese Durchgangslöcher weisen vorzugsweise einen Durchmesser von weniger als 10mm, insbesondere weniger als 2mm, weiter insbesondere weniger als 1mm, auf. Ein derartiger, geringer Durchmesser hat zur Folge, dass ein etwaiges noch hindurchtretendes elektrisches Restfeld vernachlässigbar klein ist.

Gemäß einer Ausführungsform ist die Abschirmschicht derart strukturiert, dass eine ohne die Abschirmschicht infolge unterschiedlicher thermischer Ausdehnungskoeffizienten der im Schichtaufbau des Spiegels vorhandenen Materialien bei Spiegelerwärmung bestehende Variation der thermischen Ausdehnung des Spiegels entlang der optischen Wirkfläche wenigstens teilweise kompensiert wird.

Gemäß einer Ausführungsform ist die Abschirmschicht in Bereichen unterbrochen, an welche in Stapelrichtung des Reflexionsschichtstapels jeweils eine Elektrode der ersten Elektrodenanordnung angrenzt, wobei die Abschirmschicht von diesen Elektroden insbesondere isoliert ist.

Die Abschirmschicht kann insbesondere aus Platin hergestellt sein.

Gemäß einer Ausführungsform sind die Elektroden in eine Glättschicht eingebettet.

Gemäß einer Ausführungsform ist die Abschirmschicht innerhalb der Glättschicht angeordnet.

Gemäß einer Ausführungsform ist der Spiegel für eine Arbeitswellenlänge von weniger als 30nm, insbesondere weniger als 15nm, ausgelegt. Die Erfindung ist jedoch hierauf nicht beschränkt, so dass in weiteren Anwendungen die Erfindung auch in einem optischen System mit einer Arbeitswellenlänge im VUV-Bereich (z.B. von weniger als 200nm) vorteilhaft realisiert werden kann.

Die Erfindung betrifft weiter ein optisches System einer mikrolithographischen Projektionsbelichtungsanlage, insbesondere eine Beleuchtungseinrichtung oder ein Projektionsobjektiv, mit wenigstens einem Spiegel mit den vorstehend beschriebenen Merkmalen, sowie auch eine mikrolithographische Projektionsbelichtungsanlage.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1: eine schematische Darstellung zur Erläuterung des Aufbaus eines adaptiven Spiegels gemäß einer Ausführungsform der Erfindung;
- Figur 2: ein Diagramm zur Erläuterung des Einflusses einer Vermittlerschicht in einem adaptiven Spiegel gemäß Figur 1 ;
- Figur 3: eine schematische Darstellung zur Erläuterung des Aufbaus eines adaptiven Spiegels gemäß einer weiteren Ausführungsform der Erfindung;
- Figur 4: eine schematische Darstellung zur Erläuterung des möglichen Aufbaus einer für den Betrieb im EUV ausgelegten mikrolithographischen Projektionsbelichtungsanlage;
- Figur 5: eine schematische Darstellung zur Erläuterung eines bei einem herkömmlichen adaptiven Spiegel auftretenden Problems; und
- Figur 6: eine schematische Darstellung zur Erläuterung des möglichen Aufbaus eines herkömmlichen adaptiven Spiegels.

### DETAILLIERTE BESCHREIBUNG BEVORZUGTER AUSFÜHRUNGSFORMEN

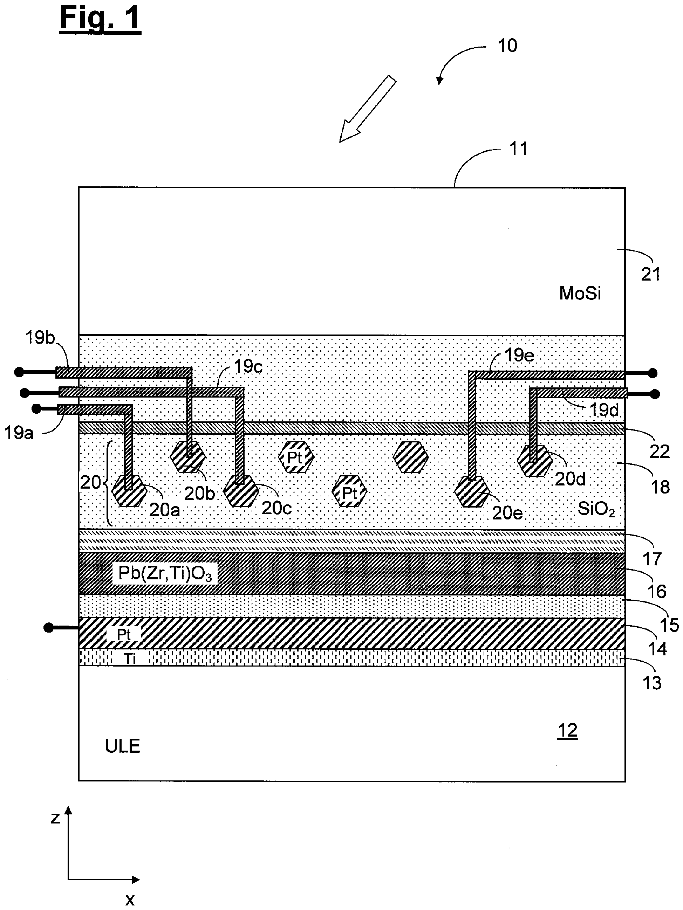

Fig. 1 zeigt eine schematische Darstellung zur Erläuterung des Aufbaus eines erfindungsgemäßen Spiegels in einer Ausführungsform der Erfindung. Der Spiegel 10 umfasst insbesondere ein Spiegelsubstrat 12, welches aus einem beliebigen geeigneten Spiegelsubstratmaterial hergestellt ist. Geeignete Spiegelsubstratmaterialien sind z.B. Titandioxid (TiO₂)-dotiertes Quarzglas, wobei lediglich beispielhaft (und ohne dass die Erfindung hierauf beschränkt wäre) die unter den Markenbezeichnungen ULE® (der Firma Corning Inc.) oder Zerodur® (der Firma Schott AG) vertriebenen Materialien verwendbar sind.

Des Weiteren weist der Spiegel 10 in grundsätzlich für sich bekannter Weise einen Reflexionsschichtstapel 21 auf, welcher in der dargestellten Ausführungsform lediglich beispielhaft einen Molybdän-Silizium (Mo-Si)-Schichtstapel umfasst. Ohne dass die Erfindung auf konkrete Ausgestaltungen dieses Schichtstapels beschränkt wäre, kann ein lediglich beispielhafter geeigneter Aufbau etwa 50 Lagen bzw. Schichtpakete eines Schichtsystems aus Molybdän (Mo)-Schichten mit einer Schichtdicke von jeweils 2.4nm und Silizium (Si)-Schichten mit einer Schichtdicke von jeweils 3.3nm umfassen.

Bei dem Spiegel 10 kann es sich insbesondere um einen EUV-Spiegel eines optischen Systems, insbesondere des Projektionsobjektivs oder der Beleuchtungseinrichtung einer mikrolithographischen Projektionsbelichtungsanlage, handeln.

Die im Betrieb des optischen Systems erfolgende Beaufschlagung der optischen Wirkfläche 11 des Spiegels 10 mit elektromagnetischer EUV-Strahlung (in Fig. 1 durch einen Pfeil angedeutet) kann eine inhomogene Volumenänderung des Spiegelsubstrats 12 aufgrund der Temperaturverteilung zur Folge haben, die aus der Absorption von inhomogen auf die optische Wirkfläche 11 auftreffender Strahlung resultiert. Zur Korrektur einer solchen unerwünschten Volumenänderung oder auch zur Korrektur anderweitiger, im Betrieb der mikrolithographischen Projektionsbelichtungsanlage auftretender Aberrationen ist der Spiegel 10 adaptiv ausgelegt, wie im Weiteren näher erläutert wird. Hierzu weist der erfindungsgemäße Spiegel 10 eine piezoelektrische Schicht 16 auf, welche im Ausführungsbeispiel aus Blei-Zirkonat-Titanat (Pb(Zr,Ti)O₃, PZT) hergestellt ist und eine beispielhafte Dicke z.B. im Bereich von 1µm bis 2µm aufweisen kann. In weiteren Ausführungsformen kann die piezoelektrische Schicht 16 auch aus einem anderen geeigneten Material (z.B. Aluminium-Nitrid (AlN), Aluminium-Scandium-Nitrid (AlScN) oder Blei-Magnesium-Niobat (PbMgNb)) hergestellt sein kann. Die piezoelektrische Schicht 16 kann beispielsweise eine Dicke von weniger als 5µm, weiter insbesondere eine Dicke im Bereich von 1µm bis 2µm aufweisen.

Ober- bzw. unterhalb der piezoelektrischen Schicht 16 befinden sich gemäß Fig. 1 jeweils (im Ausführungsbeispiel aus Platin hergestellte) Elektrodenanordnungen 14, 20, über welche der Spiegel 10 mit einem elektrischen Feld zur Erzeugung einer lokal variablen Deformation beaufschlagbar ist. Von diesen Elektrodenanordnungen 14, 20 ist die zweite, dem Substrat 12 zugewandte Elektrodenanordnung 14 als durchgehende, flächige Elektrode von konstanter Dicke ausgestaltet, wohingegen die erste Elektrodenanordnung 20 eine Mehrzahl von Elektroden 20a, 20b, 20c,... aufweist, welche jeweils über eine Zuleitung 19a, 19b, 19c,... mit einer elektrischen Spannung relativ zur ersten Elektrodenanordnung 14 beaufschlagbar sind.

In weiteren Ausführungsformen kann umgekehrt zu Fig. 1 anstelle der ersten Elektrodenanordnung 20 auch die zweite Elektrodenanordnung 14 aus einer Mehrzahl von Elektroden aufgebaut und stattdessen die erste Elektrodenanordnung als durchgehend flächige Elektrode ausgestaltet sein.

Die Elektroden 20a, 20b, 20c,... sind in eine gemeinsame Glättschicht 18 eingebettet, welche im Ausführungsbeispiel aus Quarz (SiO₂) hergestellt ist und zur Einebnung der Elektrodenanordnung 20 dient. Des Weiteren weisen die Elektroden 20a, 20b, 20c,... - ohne dass die Erfindung hierauf beschränkt wäre - eine hexagonale Geometrie auf, wobei sie insbesondere auch weitgehend flächendeckend und nur über vergleichsweise schmale Gräben voneinander isoliert angeordnet sein können. Die Erfindung ist generell nicht auf bestimmte Geometrien oder Abstände der Elektroden beschränkt (wobei der Abstand zwischen den Elektroden auch z.B. mehrere Millimeter (mm) oder mehrere Zentimeter (cm) betragen kann).

Die Zuleitungen 19a, 19b, 19c,... weisen gemäß Fig. 1 jeweils einen ersten, senkrecht zur Stapelrichtung des Reflexionsschichtstapels 21 verlaufenden Abschnitt und einen zweiten, in Stapelrichtung des Reflexionsschichtstapels 21 verlaufenden Abschnitt (auch als "Via" oder "Durchkontaktierung" bezeichnet) auf. Auch andere Arten der Kontaktierung sind möglich, wobei z.B. die Zuleitungen in weiteren Ausführungsformen auch mit lediglich einem senkrecht zur Stapelrichtung verlaufenden Abschnitt (in zweidimensionaler Auslegung und ohne "Vias") realisiert werden können.

Des Weiteren weist der Spiegel 10 gemäß Fig. 1 zwischen dem Spiegelsubstrat 12 und der dem Spiegelsubstrat 12 zugewandten unteren Elektrode 14 eine Haftschicht 13 (im Beispiel aus Titan, Ti) auf. Ferner ist mit "15" eine zwischen der dem Substrat 12 zugewandten Elektrodenanordnung 14 und der piezoelektrischen Schicht 16 vorhandene Pufferschicht bezeichnet. Diese Pufferschicht 15 dient dazu, möglichst optimale kristalline Anwachsbedingungen für die piezoelektrische Schicht bereitzustellen und kann z.B. aus LaNiO₃ hergestellt sein.

Im Betrieb des Spiegels 10 bzw. eines diesen Spiegel 10 aufweisenden optischen Systems führt das Anlegen einer elektrischen Spannung an die Elektrodenanordnungen 14 und 20 über das sich im Bereich der piezoelektrischen Schicht 16 ausbildende elektrische Feld zu einer Auslenkung dieser piezoelektrischen Schicht 16. Auf diese Weise kann (etwa zur Kompensation von optischen Aberrationen z.B. infolge thermischer Deformationen bei auf die optische Wirkfläche 11 auftreffender EUV-Strahlung) eine Aktuierung des Spiegels 10 erzielt werden.

In dem Ausführungsbeispiel von Fig. 1 weist der Spiegel 10 ferner eine Vermittlerschicht 17 auf. Diese Vermittlerschicht 17 steht in direktem elektrischem Kontakt zu den Elektroden 20a, 20b, 20c,... (welche in Fig. 1 nur zur Veranschaulichung in Draufsicht dargestellt sind). Diese Vermittlerschicht 17 bildet als solche nicht den beanspruchten Gegenstand der vorliegenden Erfindung und dient dazu, zwischen den Elektroden 20a, 20b, 20c,... der Elektrodenanordnung 20 im Potential zu "vermitteln", wobei sie eine nur geringe elektrische Leitfähigkeit (vorzugsweise weniger als 200 Siemens/Meter (S/m) aufweist mit der Folge, dass ein zwischen benachbarten Elektroden 20a, 20b, 20c,... bestehender Spannungsunterschied im Wesentlichen über der Vermittlerschicht 17 abfällt.

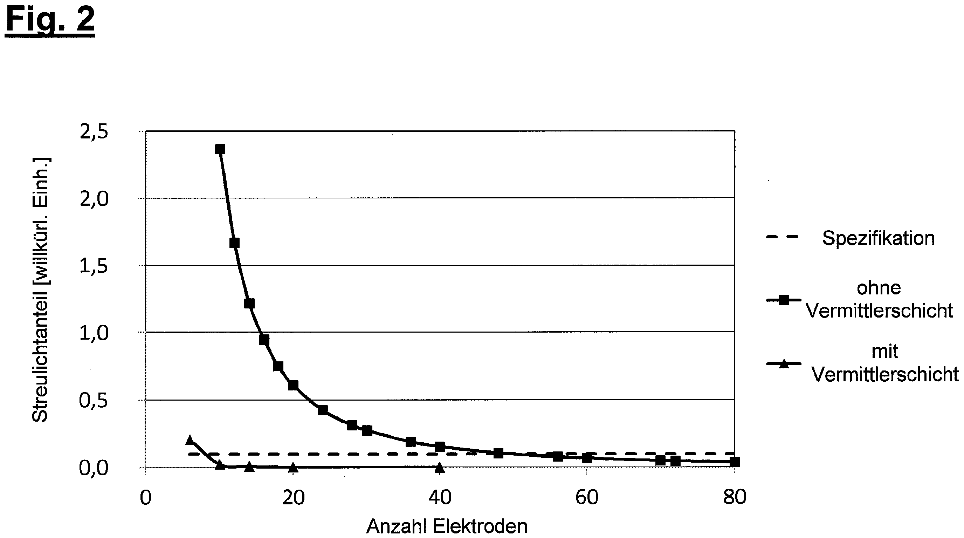

Ein aufgrund des Vorhandenseins der Vermittlerschicht 17 erzielter Vorteil ist aus dem Diagramm von Fig. 2 ersichtlich, in welchem der Streulichtanteil in Abhängigkeit von der Anzahl der in der Elektrodenanordnung 20 vorhandenen Elektroden 20a, 20b, 20c,... aufgetragen ist. Gemäß Fig. 2 ist zur Unterschreitung einer nach einer beispielhaften Spezifikation vorgegebenen oberen Schwelle für den Streulichtanteil ohne Vorhandensein der Vermittlerschicht 17 in dem gewählten Beispiel eine Anzahl von 60 Elektroden in einer von zwei zueinander senkrechten Raumrichtungen erforderlich, insgesamt also eine Anzahl von 60*60=3.600 Elektroden, wohingegen diese Anzahl bei Vorhandensein der Vermittlerschicht 17 auf weniger als 10 Elektroden in einer der zwei zueinander senkrechten Raumrichtungen reduziert werden kann mit der Folge, dass die Realisierbarkeit der Elektrodenanordnung 20 wesentlich vereinfacht wird.

Aufgrund des Umstandes, dass die Vermittlerschicht 17 einen schlechten elektrischen Leiter darstellt, kann die Vermittlerschicht 17 das elektrische Feld, welches von den Zuleitungen 19a, 19b, 19c,... der Elektroden 20a, 20b, 20c,... ausgeht, nicht signifikant abschirmen mit der Folge, dass dieses elektrische Feld durch die Vermittlerschicht 17 in die piezoelektrische Schicht 16 "durchschlagen" und dort einen piezoelektrischen Effekt hervorrufen kann. Somit würde auch von Bereichen, an denen sich keine der Elektroden 20a, 20b, 20c,... befindet, aber eine oder mehrere Zuleitungen 19a, 19b, 19c,... innerhalb der Glättschicht 18 verlaufen, elektrisches Feld bis zur piezoelektrischen Schicht 16 durchschlagen und dort einen piezoelektrischen Effekt hervorrufen, so dass sich die piezoelektrische Schicht 16 auch an Stellen ausdehnt, wo dies nicht erwünscht und auch nicht kontrollierbar ist.

Um u.a. diesem Umstand Rechnung zu tragen, ist gemäß Fig. 1 bei dem erfindungsgemäßen Spiegel nun eine Abschirmschicht 22 aus elektrisch leitendem Material derart im Schichtaufbau vorgesehen, dass eine wirksame Abschirmung des von den Zuleitungen 19a, 19b, 19c,... der dem Reflexionsschichtstapel 21 zugewandten Elektrodenanordnung 20 ausgehenden elektrischen Feldes erzielt wird, wobei zugleich der erwünschte piezoelektrische Effekt der einzelnen Elektroden 20a, 20b, 20c,... der besagten, dem Reflexionsschichtstapel 21 zugewandten Elektrodenanordnung 20 in der piezoelektrischen Schicht 16 unbeeinflusst bleibt. Hierzu ist die Abschirmschicht 22 gemäß Fig. 1 zwischen den ersten, senkrecht zur Stapelrichtung des Reflexionsschichtstapels 21 verlaufenden Abschnitten der Zuleitungen 19a, 19b, 19c,... und der ersten Elektrodenstruktur 20 angeordnet.

Des Weiteren weist die Abschirmschicht 22 Durchgangslöcher zur Hindurchführung der Zuleitungen 19a, 19b, 19c,... auf, wobei diese Durchgangslöcher vorzugsweise einen Durchmesser von weniger als 10mm, insbesondere weniger als 2mm, weiter insbesondere weniger als 1mm, besitzen. Ein derartiger, geringer Durchmesser hat zur Folge, dass ein etwaiges noch hindurchtretendes elektrisches Restfeld vernachlässigbar klein ist (wobei ein solches Restfeld ohnehin - da es von der zur jeweiligen Elektrode gehörenden Zuleitung stammt - mit der "passenden" Spannung beaufschlagt wäre).

Wenngleich der Einsatz der Vermittlerschicht 17 in dem erfindungsgemäßen adaptiven Spiegel wie vorstehend beschrieben vorteilhaft ist, ist die Erfindung nicht auf das Vorhandensein einer solchen Vermittlerschicht beschränkt. Vielmehr sollen auch Ausgestaltungen als von der Erfindung umfasst gelten, bei denen eine Abschirmschicht aus elektrisch leitendem Material zur wenigstens teilweisen Abschirmung des von den Zuleitungen der Elektroden erzeugten elektrischen Feldes in einem adaptiven Spiegel ohne die vorstehend beschriebene Vermittlerschicht vorgesehen ist.

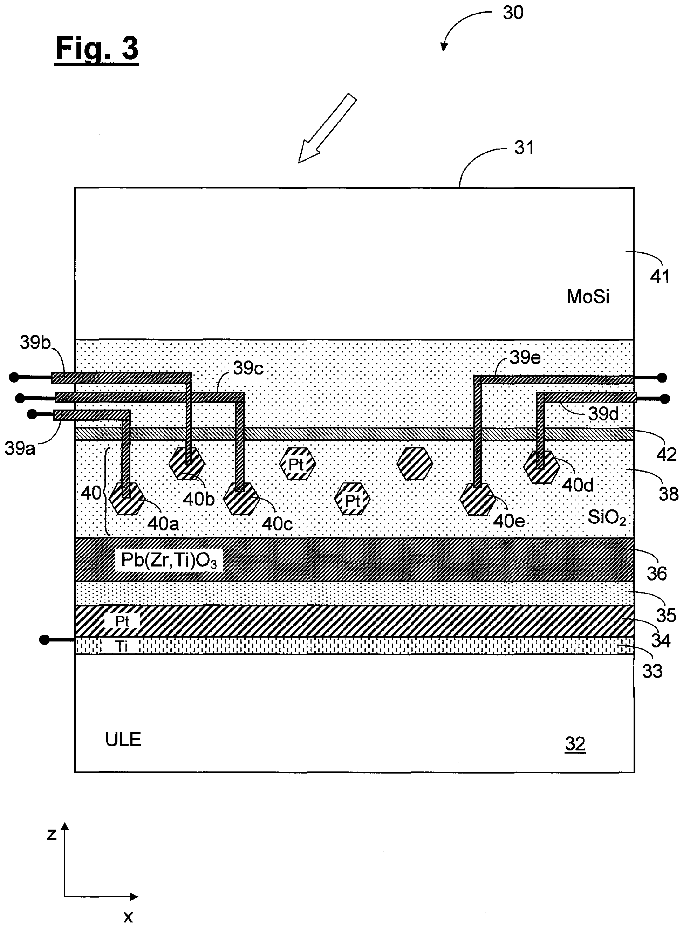

Fig. 3 zeigt eine solche Ausführungsform, wobei im Vergleich zum Ausführungsbeispiel von Fig. 1 analoge bzw. im Wesentlichen funktionsgleiche Komponenten mit um "20" erhöhten Bezugsziffern bezeichnet sind. In dem Aufbau von Fig. 3 befindet sich im Unterschied zu Fig. 1 zwischen der piezoelektrischen Schicht 36 und der Glättschicht 38, in welche die Elektroden 40a, 40b, 40c,... eingebettet sind, anstelle der (einen "schlechten" Leiter bildenden) Vermittlerschicht 17 gar keine Schicht mit der Folge, dass die erfindungsgemäße vorteilhafte Wirkung der Abschirmschicht 42 ebenfalls zum Tragen kommt, da ohne diese Abschirmschicht 42 wiederum das von den Zuleitungen 39a, 39b, 39c,... ausgehende elektrische Feld in die piezoelektrische Schicht 36 "durchschlagen" und dort einen piezoelektrischen Effekt hervorrufen würde.

Gemäß einem weiteren Aspekt der Erfindung kann durch die Abschirmschicht 22 bzw. 42 das eingangs anhand von Fig. 5 beschriebene Problem des "Durchdrückens" der Elektrodenstruktur der ersten Elektrodenanordnung in die optische Wirkfläche 51 aufgrund der im Aufbau des adaptiven Spiegels vorhandenen unterschiedlichen Materialien mit voneinander verschiedenen thermischen Ausdehnungskoeffizienten gelöst werden: Dies kann im Ergebnis dadurch erreicht werden, dass im Vergleich zu Menge und Material der Elektrodenanordnung 20 in zur Stapelrichtung des Reflexionsschichtstapels senkrechter Richtung im Wesentlichen die gleiche Menge des Materials der Abschirmschicht (z.B. Platin (Pt)) vorhanden ist mit der Folge, dass auch eine einheitliche thermische Ausdehnung stattfindet. Hierzu kann die Abschirmschicht so in den Schichtaufbau integriert werden, dass sie gerade in den Bereichen nicht vorhanden ist, welche in Stapelrichtung des Reflexionsschichtstapels an die Elektroden der ersten Elektrodenanordnung angrenzen, aber dort vorhanden ist, wo eine (mit dem Material der Glättschicht, z.B. Quarz (SiO₂) aufgefüllte) Lücke zwischen den Elektroden vorliegt. Zur Erzeugung einer solchen Abschirmschicht kann eine zur Elektrodenstrukturierung der ersten Elektrodenanordnung inverse Strukturierung durchgeführt werden. Des Weiteren sollte vorzugsweise in dieser Ausgestaltung die Dicke der Abschirmschicht mit der Dicke der Elektroden der ersten Elektrodenanordnung übereinstimmen.

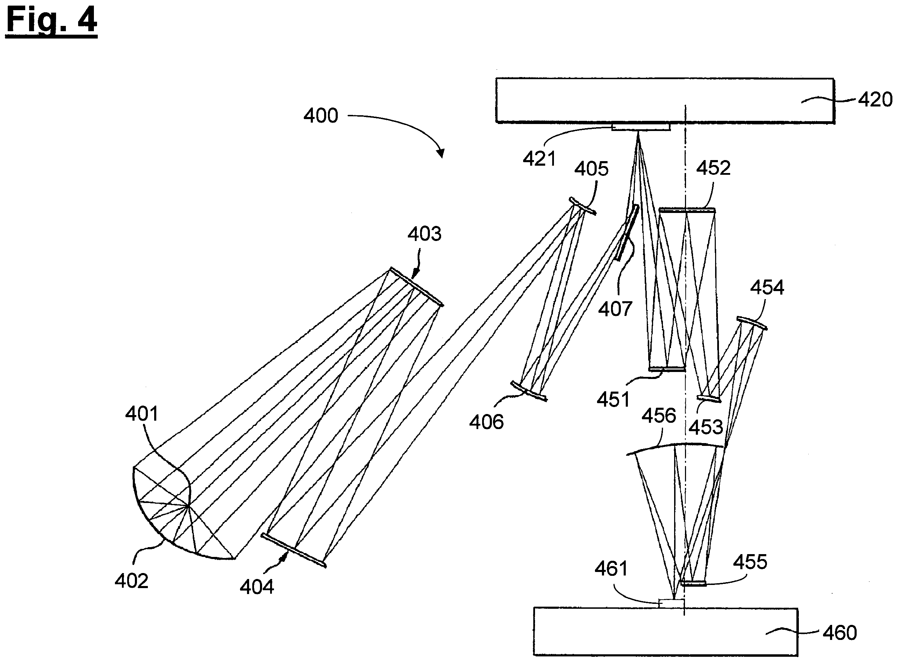

Fig. 4 zeigt eine schematische Darstellung einer beispielhaften für den Betrieb im EUV ausgelegten Projektionsbelichtungsanlage, in welcher die vorliegende Erfindung realisierbar ist. Gemäß Fig. 4 weist eine Beleuchtungseinrichtung in einer für EUV ausgelegten Projektionsbelichtungsanlage 400 einen Feldfacettenspiegel 403 und einen Pupillenfacettenspiegel 404 auf. Auf den Feldfacettenspiegel 403 wird das Licht einer Lichtquelleneinheit, welche eine Plasmalichtquelle 401 und einen Kollektorspiegel 402 umfasst, gelenkt. Im Lichtweg nach dem Pupillenfacettenspiegel 404 sind ein erster Teleskopspiegel 405 und ein zweiter Teleskopspiegel 406 angeordnet. Im Lichtweg nachfolgend ist ein Umlenkspiegel 407 angeordnet, der die auf ihn treffende Strahlung auf ein Objektfeld in der Objektebene eines sechs Spiegel 451-456 umfassenden Projektionsobjektivs lenkt. Am Ort des Objektfeldes ist eine reflektive strukturtragende Maske 421 auf einem Maskentisch 420 angeordnet, die mit Hilfe des Projektionsobjektivs in eine Bildebene abgebildet wird, in welcher sich ein mit einer lichtempfindlichen Schicht (Photoresist) beschichtetes Substrat 461 auf einem Wafertisch 460 befindet.

Von den Spiegeln 451-456 des Projektionsobjektivs können insbesondere die - bezogen auf den optischen Strahlengang im Anfangsbereich des Projektionsobjektivs angeordneten - Spiegel 451 und 452 in der erfindungsgemäßen Weise ausgestaltet sein, da der erzielte Effekt einer Kompensation thermischer Deformationen infolge der an diesen Spiegeln 451, 452 aufgrund der noch vergleichsweise geringen aufsummierten Reflexionsverluste und damit der relativ hohen Lichtintensitäten dann besonders ausgeprägt ist.

## Patentansprüche

1. Spiegel, wobei der Spiegel eine optische Wirkfläche (11, 31) aufweist, mit
• einem Spiegelsubstrat (12, 32);
• einem Reflexionsschichtstapel (21, 41) zur Reflexion von auf die optische Wirkfläche (11, 31) auftreffender elektromagnetischer Strahlung; und
• wenigstens einer piezoelektrischen Schicht (16, 36), welche zwischen Spiegelsubstrat (12, 32) und Reflexionsschichtstapel (21, 41) angeordnet und über eine erste, auf der dem Reflexionsschichtstapel (21, 41) zugewandten Seite der piezoelektrischen Schicht (16, 36) befindliche Elektrodenanordnung (20, 40) und eine zweite, auf der dem Spiegelsubstrat (12, 32) zugewandten Seite der piezoelektrischen Schicht (16, 36) befindliche Elektrodenanordnung (14, 34) mit einem elektrischen Feld zur Erzeugung einer lokal variablen Deformation beaufschlagbar ist;
• wobei die erste Elektrodenanordnung (20, 40) und/oder die zweite Elektrodenanordnung (14, 34) eine Mehrzahl von Elektroden (20a, 20b, 20c,..., 40a, 40b, 40c,...) aufweist, welche jeweils über eine Zuleitung (19a, 19b, 19c,..., 39a, 39b, 39c,...) mit einer elektrischen Spannung bezogen auf die jeweils andere Elektrodenanordnung beaufschlagbar sind;
• wobei ferner eine Abschirmschicht (22, 42) aus elektrisch leitendem Material derart angeordnet ist, dass sie ein von diesen Zuleitungen (19a, 19b, 19c,..., 39a, 39b, 39c,...) erzeugtes elektrisches Feld wenigstens teilweise von der piezoelektrischen Schicht (16, 36) abschirmt;
• wobei die Abschirmschicht (22, 42) aus einem Material mit einer elektrischen Leitfähigkeit von mehr als 10⁶ Siemens/Meter hergestellt ist.

2. Spiegel nach Anspruch 1, **dadurch gekennzeichnet, dass** zwischen der piezoelektrischen Schicht (16) und der die Mehrzahl von Elektroden (20a, 20b, 20c,..., 40a, 40b, 40c,...) aufweisenden Elektrodenanordnung (20) ferner eine Vermittlerschicht (17) aus einem Material mit einer elektrischen Leitfähigkeit von weniger als 200 Siemens/Meter (S/m) angeordnet ist.

3. Spiegel nach Anspruch 1 oder 2, **dadurch gekennzeichnet, dass** die Abschirmschicht (22, 42) auf der der piezoelektrischen Schicht (16) abgewandten Seite der die Mehrzahl von Elektroden (20a, 20b, 20c,..., 40a, 40b, 40c,...) aufweisenden Elektrodenanordnung (20, 40) angeordnet ist.

4. Spiegel nach einem der Ansprüche 1 bis 3, **dadurch gekennzeichnet, dass** die Zuleitungen (19a, 19b, 19c,..., 39a, 39b, 39c,...) jeweils einen ersten, senkrecht zur Stapelrichtung des Reflexionsschichtstapels (21, 41) verlaufenden Abschnitt und einen zweiten, in Stapelrichtung des Reflexionsschichtstapels (21, 41) verlaufenden Abschnitt aufweisen.

5. Spiegel nach Anspruch 4, **dadurch gekennzeichnet, dass** die Abschirmschicht (22, 42) zwischen den ersten, senkrecht zur Stapelrichtung des Reflexionsschichtstapels (21, 41) verlaufenden Abschnitten der Zuleitungen (19a, 19b, 19c,..., 39a, 39b, 39c,...) und der die Mehrzahl von Elektroden (20a, 20b, 20c,..., 40a, 40b, 40c,...) aufweisenden Elektrodenanordnung (20, 40) angeordnet ist.

6. Spiegel nach einem der vorhergehenden Ansprüche, **dadurch gekennzeichnet, dass** die Abschirmschicht (22, 42) Durchgangslöcher zur Hindurchführung der Zuleitungen (19a, 19b, 19c,..., 39a, 39b, 39c,...) aufweist.

7. Spiegel nach einem der vorhergehenden Ansprüche, **dadurch gekennzeichnet, dass** die Abschirmschicht derart strukturiert ist, dass eine ohne die Abschirmschicht infolge unterschiedlicher thermischer Ausdehnungskoeffizienten der im Schichtaufbau des Spiegels vorhandenen Materialien bei Spiegelerwärmung bestehende Variation der thermischen Ausdehnung des Spiegels entlang der optischen Wirkfläche wenigstens teilweise kompensiert wird.

8. Spiegel nach einem der vorhergehenden Ansprüche, **dadurch gekennzeichnet, dass** die Abschirmschicht in Bereichen unterbrochen ist, an welche in Stapelrichtung des Reflexionsschichtstapels jeweils eine Elektrode der ersten Elektrodenanordnung angrenzt.

9. Spiegel nach einem der vorhergehenden Ansprüche, **dadurch gekennzeichnet, dass** die Abschirmschicht (22, 42) aus Platin hergestellt ist.

10. Spiegel nach einem der vorhergehenden Ansprüche, **dadurch gekennzeichnet, dass** die Elektroden (20a, 20b, 20c,..., 40a, 40b, 40c,...) in eine Glättschicht (18, 38) eingebettet sind.

11. Spiegel nach Anspruch 10, **dadurch gekennzeichnet, dass** die Abschirmschicht (22, 42) innerhalb der Glättschicht (18, 38) angeordnet ist.

12. Spiegel nach einem der vorhergehenden Ansprüche, **dadurch gekennzeichnet, dass** der Spiegel für eine Arbeitswellenlänge von weniger als 30 nm, insbesondere weniger als 15 nm, ausgelegt ist.

13. Spiegel nach einem der vorhergehenden Ansprüche, **dadurch gekennzeichnet, dass** dieser ein Spiegel für eine mikrolithographische Projektionsbelichtungsanlage ist.

14. Optisches System, insbesondere Beleuchtungseinrichtung oder Projektionsobjektiv einer mikrolithographischen Projektionsbelichtungsanlage, **dadurch gekennzeichnet, dass** das optische System einen Spiegel nach einem der vorhergehenden Ansprüche aufweist.

15. Mikrolithographische Projektionsbelichtungsanlage (200) mit einer Beleuchtungseinrichtung und einem Projektionsobjektiv, **dadurch gekennzeichnet, dass** die Projektionsbelichtungsanlage ein optisches System nach Anspruch 14 aufweist.

## Claims

1. Mirror, wherein the mirror has an optical effective surface (11, 31), comprising
• a mirror substrate (12, 32);
• a reflection layer stack (21, 41) for reflecting electromagnetic radiation that is incident on the optical effective surface (11, 31); and
• at least one piezoelectric layer (16, 36), which is arranged between the mirror substrate (12, 32) and the reflection layer stack (21, 41) and to which an electric field can be applied for producing a locally variable deformation via a first electrode arrangement (20, 40), located on the side of the piezoelectric layer (16, 36) that faces the reflection layer stack (21, 41), and a second electrode arrangement (14, 34), located on the side of the piezoelectric layer (16, 36) that faces the mirror substrate (12, 32);
• wherein the first electrode arrangement (20, 40) and/or the second electrode arrangement (14, 34) has a plurality of electrodes (20a, 20b, 20c,..., 40a, 40b, 40c,...) to which a voltage with respect to the respectively other electrode arrangement can be applied in each case via a supply line (19a, 19b, 19c,..., 39a, 39b, 39c,...);
• wherein furthermore a shielding layer (22, 42) made from electrically conductive material is arranged such that the shielding layer (22, 42) at least partially shields an electric field produced by said supply lines (19a, 19b, 19c,..., 39a, 39b, 39c,...) from the piezoelectric layer (16, 36);
• wherein the shielding layer (22, 42) is produced from a material having an electrical conductivity of more than 10⁶ siemens/metre.

2. Mirror according to Claim 1, **characterized in that** furthermore a mediation layer (17) made from a material having an electrical conductivity of less than 200 siemens/metre (S/m) is arranged between the piezoelectric layer (16) and the electrode arrangement (20) having the plurality of electrodes (20a, 20b, 20c,..., 40a, 40b, 40c,...) .

3. Mirror according to Claim 1 or 2, **characterized in that** the shielding layer (22, 42) is arranged on that side of the electrode arrangement (20, 40) having the plurality of electrodes (20a, 20b, 20c,..., 40a, 40b, 40c,...) that faces away from the piezoelectric layer (16).

4. Mirror according to one of Claims 1 to 3, **characterized in that** the supply lines (19a, 19b, 19c,..., 39a, 39b, 39c,...) each have a first portion extending perpendicular to the stack direction of the reflection layer stack (21, 41) and a second portion extending in the stack direction of the reflection layer stack (21, 41) .

5. Mirror according to Claim 4, **characterized in that** the shielding layer (22, 42) is arranged between the first portions of the supply lines (19a, 19b, 19c,..., 39a, 39b, 39c,...) extending perpendicular to the stack direction of the reflection layer stack (21, 41) and the electrode arrangement (20, 40) having the plurality of electrodes (20a, 20b, 20c,..., 40a, 40b, 40c,...).

6. Mirror according to one of the preceding claims, **characterized in that** the shielding layer (22, 42) has through-holes for guiding the supply lines (19a, 19b, 19c,..., 39a, 39b, 39c,...) through them.

7. Mirror according to one of the preceding claims, **characterized in that** the shielding layer is structured such that a variation in the thermal expansion of the mirror along the optical effective surface occurring in the case of mirror heating without the shielding layer as a consequence of different coefficients of thermal expansion of the materials present in the layer system of the mirror is at least partially compensated.

8. Mirror according to one of the preceding claims, **characterized in that** the shielding layer is interrupted in regions adjoined in each case by an electrode of the first electrode arrangement in the stack direction of the reflection layer stack.

9. Mirror according to one of the preceding claims, **characterized in that** the shielding layer (22, 42) is produced from platinum.

10. Mirror according to one of the preceding claims, **characterized in that** the electrodes (20a, 20b, 20c,..., 40a, 40b, 40c,...) are embedded in a smoothing layer (18, 38) .

11. Mirror according to Claim 10, **characterized in that** the shielding layer (22, 42) is arranged inside the smoothing layer (18, 38).

12. Mirror according to one of the preceding claims, **characterized in that** the mirror is designed for an operating wavelength of less than 30 nm, in particular less than 15 nm.

13. Mirror according to one of the preceding claims, **characterized in that** said mirror is a mirror for a microlithographic projection exposure apparatus.

14. Optical system, in particular illumination device or projection lens of a microlithographic projection exposure apparatus, **characterized in that** the optical system has a mirror according to one of the preceding claims.

15. Microlithographic projection exposure apparatus (200) having an illumination device and a projection lens, **characterized in that** the projection exposure apparatus has an optical system according to Claim 14.

## Revendications

1. Miroir, le miroir possédant une surface active optique (11, 31), comprenant
• un substrat de miroir (12, 32) ;
• une pile de couches de réflexion (21, 41) servant à la réflexion du rayonnement électromagnétique qui vient frapper la surface active optique (11, 31) ; et
• au moins une couche piézoélectrique (16, 36), qui est disposée entre le substrat de miroir (12, 32) et la pile de couches de réflexion (21, 41), et qui peut être soumise, par le biais d'un premier arrangement d'électrodes (20, 40) qui se trouve sur le côté de la couche piézoélectrique (16, 36) faisant face à la pile de couches de réflexion (21, 41) et un deuxième arrangement d'électrodes (14, 34) qui se trouve sur le côté de la couche piézoélectrique (16, 36) faisant face au substrat de miroir (12, 32), à un champ électrique destiné à générer une déformation variable localement ;
• le premier arrangement d'électrodes (20, 40) et/ou le deuxième arrangement d'électrodes (14, 34) possédant une pluralité d'électrodes (20a, 20b, 20c, ..., 40a, 40b, 40c, ...) qui peuvent être alimentées, respectivement par le biais d'une ligne d'arrivée (19a, 19b, 19c, ..., 39a, 39b, 39c, ...), avec une tension électrique en référence à l'autre arrangement d'électrodes respectif ;
• une couche de blindage (22, 42) en matériau électriquement conducteur étant en outre disposée de telle sorte qu'elle assure une protection par blindage au moins partielle de la couche piézoélectrique (16, 36) contre un champ électrique généré par ces lignes d'arrivée (19a, 19b, 19c, ..., 39a, 39b, 39c, ...) ;
• la couche de blindage (22, 42) étant produite dans un matériau ayant une conductivité électrique supérieure à 10⁶ Siemens/mètre.

2. Miroir selon la revendication 1, **caractérisé en ce qu'**une couche de transmission (17) en un matériau ayant une conductivité électrique inférieure à 200 Siemens/mètre (S/m) est en outre disposée entre la couche piézoélectrique (16) et l'arrangement d'électrodes (20) qui possède la pluralité d'électrodes (20a, 20b, 20c, ..., 40a, 40b, 40c, ...) .

3. Miroir selon la revendication 1 ou 2, **caractérisé en ce que** la couche de blindage (22, 42) est disposée sur le côté de l'arrangement d'électrodes (20, 40) qui possède la pluralité d'électrodes (20a, 20b, 20c, ..., 40a, 40b, 40c, ...) à l'opposé de la couche piézoélectrique (16).

4. Miroir selon l'une des revendications 1 à 3, **caractérisé en ce que** les lignes d'arrivée (19a, 19b, 19c, ..., 39a, 39b, 39c, ...) possèdent respectivement une première portion, qui suit un tracé perpendiculaire à la direction d'empilement de la pile de couches de réflexion (21, 41), et une deuxième portion, qui suit un tracé dans la direction d'empilement de la pile de couches de réflexion (21, 41).

5. Miroir selon la revendication 4, **caractérisé en ce que** la couche de blindage (22, 42) est disposée entre les premières portions des lignes d'arrivée (19a, 19b, 19c, ..., 39a, 39b, 39c, ...), qui suivent un tracé perpendiculaire à la direction d'empilement de la pile de couches de réflexion (21, 41), et l'arrangement d'électrodes (20, 40) qui possède la pluralité d'électrodes (20a, 20b, 20c, ..., 40a, 40b, 40c, ...) .

6. Miroir selon l'une des revendications précédentes, **caractérisé en ce que** la couche de blindage (22, 42) possède des trous de passage destinés à y faire passer les lignes d'arrivée (19a, 19b, 19c, ..., 39a, 39b, 39c, ...) .

7. Miroir selon l'une des revendications précédentes, **caractérisé en ce que** la couche de blindage est structurée de telle sorte qu'une variation de la dilatation thermique du miroir le long de la surface active optique, qui se produit lors du réchauffement du miroir en l'absence de la couche de blindage en raison des coefficients de dilatation thermique différents des matériaux présents dans la structure en couches, est au moins partiellement compensée.

8. Miroir selon l'une des revendications précédentes, **caractérisé en ce que** la couche de blindage est interrompue dans les zones au niveau desquelles la direction d'empilement de la pile de couches de réflexion est respectivement voisine d'une électrode du premier arrangement d'électrodes.

9. Miroir selon l'une des revendications précédentes, **caractérisé en ce que** la couche de blindage (22, 42) est fabriquée en platine.

10. Miroir selon l'une des revendications précédentes, **caractérisé en ce que** les électrodes (20a, 20b, 20c, ..., 40a, 40b, 40c, ...) sont enrobées dans une couche lisse (18, 38).

11. Miroir selon la revendication 10, **caractérisé en ce que** la couche de blindage (22, 42) est disposée à l'intérieur de la couche lisse (18, 38).

12. Miroir selon l'une des revendications précédentes, **caractérisé en ce que** le miroir est conçu pour une longueur d'onde de travail inférieure à 30 nm, notamment inférieure à 15 nm.

13. Miroir selon l'une des revendications précédentes, **caractérisé en ce que** celui-ci est un miroir pour un équipement d'éclairage de projection microlithographique.

14. Système optique, notamment dispositif d'éclairage ou objectif de projection d'un équipement d'éclairage de projection microlithographique, **caractérisé en ce que** le système optique possède un miroir selon l'une des revendications précédentes.

15. Équipement d'éclairage de projection microlithographique (200) comprenant un dispositif d'éclairage et un objectif de projection, **caractérisé en ce que** l'équipement d'éclairage de projection possède un système optique selon la revendication 14.
